# EUROPEAN PATENT APPLICATION

(11) **EP 4 459 375 A1**
(43) Date of publication of application: **06.11.2024**
(21) Application number: 22915925.6
(22) Date of filing: 22.12.2022
(51) Int. Cl.: G03F 7/027, B41N 1/00, C08L 9/00, C08L 53/02, G03F 7/00

(54) **PHOTOSENSITIVE RESIN COMPOSITION**

(30) Priority: 28.12.2021 JP 2021214548
(71) Applicant: Kuraray Co., Ltd., Kurashiki-shi, Okayama 710-0801 (JP)
(72) Inventor: UENO, Yoshikazu, Tokyo 100-0004 (JP); UEHARA, Yosuke, Kamisu-shi, Ibaraki 314-0197 (JP)
(74) Representative: Müller-Boré & Partner Patentanwälte PartG mbB
(86) International application number: PCT/JP2022/047473
(87) International publication number: WO 2023/127702

(57) **Abstract**

Provided is a photosensitive resin composition comprising a thermoplastic elastomer (A), a liquid farnesene rubber (B), an ethylenically unsaturated compound (C), and a photoinitiator (D).

## Description

### Technical Field

The present invention relates to a photosensitive resin composition and a flexographic printing plate obtained by using the photosensitive resin composition.

### Background Art

A photosensitive resin composition used in a flexographic printing plate generally contains a thermoplastic elastomer, a photopolymerizable unsaturated monomer, a plasticizer, such as a conjugated diene rubber, and a photopolymerization initiator (see, for example, PTLs 1 to 4).

A constituent body for a flexographic printing plate generally includes a polyester film as a support and a photosensitive layer formed of the aforementioned photosensitive resin composition provided on the polyester film. In addition, a slip layer or protective layer is provided, as required, on the photosensitive layer for the purpose of smoothening the contact with a negative film.

For forming a flexographic printing plate from such a constituent body for a flexographic printing plate, in general, the entire surface is first subjected to ultraviolet light exposure through the support (back exposure) to provide a thin uniform cured layer on the interface of the photosensitive layer with the support, and then, the surface of the photosensitive layer is subjected to image exposure (relief exposure) to ultraviolet light thorough a negative film that covers the top of the photosensitive layer. Then, an unexposed part of the photosensitive layer is washed out with a developer, or is thermally melted and then removed by absorption with an absorbing layer, followed by post-treatment exposure.

### Citation List

### Patent Literature

PTL 1: JP 2000-155418 A
PTL 2: JP 2007-148322 A
PTL 3: WO 2005/121896 A1
PTL 4: JP H04-342258 A

### Summary of Invention

### Technical Problem

In flexographic printing, in general, a plurality of printing plates is formed with one negative film. Since a photosensitive layer generally has viscidity, when a negative film is directly placed on a photosensitive layer, the negative film sticked to the photosensitive layer may break in peeling the negative film from the photosensitive layer after image exposure so that the negative film cannot be reused. Thus, a photosensitive layer is required to have such a low tackiness that a negative film can be easily peeled and is reusable.

However, in photosensitive layers obtained by using the photosensitive resin compositions described in the above PTLs 1 to 4, the tackiness cannot be sufficiently decreased.

In addition, the printing plate is also required to suppress attachment of dust and tear of an object to be printed in printing, thus being superior in the printing performance. Moreover, the printing plate is also required to undergo a small change in properties with time, thus being superior in stability of the printing performance.

Thus, the present invention has a first object to provide a photosensitive resin composition that gives a low tackiness before and after curing and gives a low rate of extraction after curing.

The present invention has a second object to provide a photosensitive resin composition that gives a low tackiness before and after curing while maintaining a low rate of extraction after curing.

### Solution to Problem

As a result of intensive and extensive studies for solving the above problem, the present inventors have found that the problem can be solved by incorporating a liquid farnesene rubber into a photosensitive resin composition, thus completing the present invention.

Specifically, the present invention is as follows.
[1] A photosensitive resin composition comprising a thermoplastic elastomer (A), a liquid farnesene rubber (B), an ethylenically unsaturated compound (C), and a photoinitiator (D).
[2] The photosensitive resin composition according to [1], in which the thermoplastic elastomer (A) is at least one selected from the group consisting of a styrene-butadiene-styrene block copolymer, a styrene-isoprene-styrene block copolymer, a styrene-(ethylene-butylene)-styrene block copolymer, and a styrene-(ethylene-propylene)-styrene block copolymer.
[3] The photosensitive resin composition according to the above [1] or [2], in which the liquid farnesene rubber (B) comprises a farnesene-derived monomer unit in an amount of 10% by mass or more.
[4] The photosensitive resin composition according to any one of the above [1] to [3], in which the liquid farnesene rubber (B) has a number average molecular weight of 7,000 to 150,000.
[5] The photosensitive resin composition according to any one of the above [1] to [4], in which the liquid farnesene rubber (B) has a glass transition temperature of -60°C or lower.
[6] The photosensitive resin composition according to any one of the above [1] to [5], in which the liquid farnesene rubber (B) has a vinyl content of 5 to 80% by mole.
[7] The photosensitive resin composition according to any one of the above [1] to [6], in which the thermoplastic elastomer (A) is at least one selected from the group consisting of a styrene-butadiene-styrene block copolymer and a styrene-isoprene-styrene block copolymer.
[8] The photosensitive resin composition according to [7], in which the thermoplastic elastomer (A) comprises a styrene-butadiene-styrene block copolymer.
[9] The photosensitive resin composition according to [7], in which the thermoplastic elastomer (A) comprises a styrene-isoprene-styrene block copolymer.
[10] The photosensitive resin composition according to any one of the above [1] to [9], in which the thermoplastic elastomer (A) is contained in an amount of 40 to 87.9% by mass, the liquid farnesene rubber (B) is contained in an amount of 10 to 40% by mass, the ethylenically unsaturated compound (C) is contained in an amount of 2 to 30% by mass, and the photoinitiator (D) is contained in an amount of 0.1 to 10% by mass, based on the total amount of the photosensitive resin composition.
[11] A flexographic printing plate having a photosensitive layer composed of the photosensitive resin composition according to any one of the above [1] to [10].
[12] A laminated body having a layer composed of the photosensitive resin composition according to any one of the above [1] to [10].

### Advantageous Effects of Invention

According to the present invention, it is possible to provide a photosensitive resin composition that gives a low tackiness before and after curing and gives a low rate of extraction after curing.

### Description of Embodiments

The present invention will be described below based on an example of embodiments of the present invention. Note that the embodiment shown below is an example for embodying the technical idea of the present invention, and the present invention is not limited to the following description.

Preferred aspects of embodiments are shown in this description, and an aspect that is a combination of two or more individual preferred aspects is also a preferred aspect. For an item expressed with a numerical range, when there are several numerical ranges, the upper limits and the lower limits thereof can be selectively combined to make a preferred aspect.

In this description, a description of a numerical range represented by "XX to YY" means "XX or more and YY or less".

### <Photosensitive Resin Composition>

The photosensitive resin composition according to the present invention is characterized by containing a thermoplastic elastomer (A), a liquid farnesene rubber (B), an ethylenically unsaturated compound (C), and a photoinitiator (D).

### [Thermoplastic Elastomer (A)]

The thermoplastic elastomer (A) used in the present invention is a polymer that can be plasticized and molded at a high temperature and that has the properties of a rubber elastic body at a normal temperature. The thermoplastic elastomer (A) is not particularly limited, and is preferably a styrene-based block copolymer from the viewpoints of availability and moldability of the printing plate.

The styrene-based block copolymer is a block copolymer that has at least a polymer block mainly constituted of a styrene-derived structural unit (hereinafter sometimes referred to as "polymer block (a)") and a polymer block constituted of a conjugated diene-derived structural unit (hereinafter sometimes referred to as "polymer block (b)"). The polymer block mainly constituted of a styrene-derived structural unit preferably contains a styrene-derived structural unit in an amount of 90% by mass or more, more preferably 95% by mass or more, and further preferably is constituted only of a styrene-derived structural unit. The polymer block mainly constituted of a styrene-derived structural unit may contain a structural unit derived from a styrene-based monomer other than styrene. Examples of the styrene-based monomer other than styrene include α-methylstyrene, o-methylstyrene, m-methylstyrene, p-methylstyrene, p-t-butylstyrene, 2,4-dimethylstyrene, vinylnaphthalene, and vinylanthracene. On the other hand, examples of the conjugated diene in the polymer block constituted of a conjugated diene-derived structural unit include butadiene, isoprene, chloroprene, 2,3-dimethylbutadiene, 1,3-pentadiene, and 1,3-hexadiene. Among them, from the viewpoint of availability, butadiene and isoprene are preferred.

One of the monomers or the conjugated dienes may be used alone or two or more thereof may be used in combination.

The olefinic double bond in the styrene-based block copolymer is preferably a nonhydrogenated one, but 10% by mole or less of the carbon-carbon double bonds in the conjugated diene-derived structural unit may be hydrogenated.

The content of the polymer block (a) in the styrene-based block copolymer is, from the viewpoint of effectively exhibiting a reduction of the tackiness, preferably 5% by mass or more, more preferably 10% by mass or more, further preferably 15% by mass or more, and from the viewpoint of moldability, preferably 50% by mass or less, more preferably 40% by mass or less, further preferably 35% by mass or less.

The content of the polymer block (b) in the styrene-based block copolymer is preferably 50% by mass or more, more preferably 60% by mass or more, further preferably 65% by mass or more, and preferably 95% by mass or less, more preferably 90% by mass or less, further preferably 85% by mass or less.

Specific examples of the thermoplastic elastomer (A) include a styrene-butadiene-styrene block copolymer (SBS), a styrene-isoprene-styrene block copolymer (SIS), a styrene-(ethylene-butylene)-styrene block copolymer (SEBS), and a styrene-(ethylene-propylene)-styrene block copolymer (SEPS). Among them, from the viewpoints of moldability of the printing plate and image reproductivity, the thermoplastic elastomer (A) is preferably at least one selected from the group consisting of a styrene-butadiene-styrene block copolymer and a styrene-isoprene-styrene block copolymer. In one embodiment, the thermoplastic elastomer (A) contains a styrene-butadiene-styrene block copolymer. In another embodiment, the thermoplastic elastomer (A) contains a styrene-isoprene-styrene block copolymer. Said another embodiment is suitable in the case where a printing plate that is thinner and harder than an ordinary printing plate is to be produced. The thermoplastic elastomer (A) may contain a styrene-butadiene-styrene block copolymer and a styrene-isoprene-styrene block copolymer. The thermoplastic elastomer (A) may be a styrene-butadiene-styrene block copolymer and a styrene-butadiene/isoprene-styrene block copolymer. Here, the "butadiene/isoprene" means a copolymer block having butadiene and isoprene as constitutional monomers.

Examples of commercial products of the thermoplastic elastomer (A) include "KRATON D" (trade name) manufactured by KRATON CORPORATION, "Tufprene (registered trademark)" (trade name) and "Asaprene (registered trademark) T" (trade name) manufactured by Asahi Kasei Chemicals Corporation, "JSR TR" (trade name) and "JSR SIS" (trade name) manufactured by JSR Corporation, "Quintac (registered trademark)" (trade name) manufactured by Zeon Corporation, and "HYBRAR 5125" (trade name) and "HYBRAR 5127" (trade name) manufactured by KURARAY CO., LTD.

The weight average molecular weight (Mw) of the thermoplastic elastomer (A) is not particularly limited, and is preferably 10,000 to 1,000,000, more preferably 50,000 to 400,000, further preferably 80,000 to 250,000, furthermore preferably 80,000 to 200,000. When Mw of the thermoplastic elastomer (A) is 10,000 or more, the mechanical strength of the printing plate can be increased, and when Mw is 1,000,000 or less, the moldability of the printing plate can be increased. When Mw of the thermoplastic elastomer (A) is 10,000 or more, the mechanical strength of the printing plate can be increased, and when Mw is 1,000,000 or less, the moldability of the printing plate can be increased.

The weight average molecular weight in this description is a weight average molecular weight based on polystyrenes measured by gel permeation chromatography (GPC).

The vinyl content of the polymer block constituted of a conjugated diene-derived structural unit in the thermoplastic elastomer (A) is, from the viewpoint of the curability of the composition, preferably 1 to 50% by mole, more preferably 5 to 50% by mole, further preferably 5 to 40% by mole, furthermore preferably 5 to 30% by mole, and particularly preferably 10 to 30% by mole. The vinyl content is, from the viewpoint of the cold flow resistance of the composition, preferably 40 to 80% by mole, more preferably 50 to 80% by mole, further preferably 50 to 75% by mole.

The content of the thermoplastic elastomer (A) based on the total amount of the photosensitive resin composition is preferably 40 to 87.9% by mass, more preferably 50 to 85% by mass, further preferably 60 to 80% by mass. When the content of the thermoplastic elastomer (A) is 40% by mass or more, the tackiness before and after curing of the composition can be further decreased, and when the content is 87.9% by mass or less, the flexibility of the composition can be increased.

### [Liquid Farnesene Rubber (B)]

The liquid farnesene rubber (B) used in the present invention is a rubber which can be handled in the form of liquid.

In this description, the "liquid" means that the liquid farnesene rubber (B) has a melt viscosity measured at 38°C of 0.1 to 4,000 Pa·s. The melt viscosity is preferably 1 to 2,000 Pa s, more preferably 2 to 1,000 Pa s, further preferably 10 to 750 Pa s, furthermore preferably 10 to 500 Pa s. In another embodiment, the melt viscosity is preferably 0.3 to 2,000 Pa s, more preferably 0.5 to 1,000 Pa·s, further preferably 0.7 to 750 Pa s, furthermore preferably 0.7 to 500 Pa s. The melt viscosity of the liquid farnesene rubber (B) is a value measured with a Brookfield viscometer at 38°C.

### <Monomer Unit (a)>

The liquid farnesene rubber (B) is a liquid polymer containing a farnesene-derived monomer unit (a) (hereinafter also simply referred to as "monomer unit (a)").

The monomer unit (a) may be an α-farnesene-derived monomer unit, may be a β-farnesene-derived monomer unit represented by the following formula (I), or may contain the α-farnesene-derived monomer unit and the β-farnesene-derived monomer unit. From the viewpoint of production easiness, the β-farnesene-derived monomer unit is preferably contained.

The content of the β-farnesene-derived monomer unit in the monomer unit (a) is, from the viewpoint of production easiness, preferably 80% by mole or more, more preferably 90% by mole or more, and further preferably 100% by mole, that is, all of the monomer units (a) are the β-farnesene-derived monomer units.

The content of the monomer unit (a) in the liquid farnesene rubber (B) is, from the viewpoint of the curability of the composition and further reducing the tackiness before and after curing, preferably 10% by mass or more, more preferably 30% by mass or more, further preferably 50% by mass or more. The upper limit of the content of the monomer unit (a) in the liquid farnesene rubber (B) is not particularly limited, and may be 100% by mass, or can be less than 100% by mass, 99% by mass or less, 90% by mass or less, or 80% by mass or less. In one embodiment, the liquid farnesene rubber (B) contains another monomer unit, and the content of the monomer unit (a) is less than 100% by mass, preferably 99% by mass or less. In another embodiment, the content of the monomer unit (a) in the liquid farnesene rubber (B) is 100% by mass.

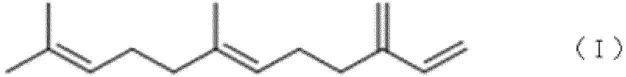

### <Monomer Unit (b)>

The liquid farnesene rubber (B) may be a liquid copolymer containing the monomer unit (a) and a monomer unit derived from a monomer other than farnesene (b) (hereinafter sometimes simply referred to as "monomer unit (b)").

When the liquid farnesene rubber (B) is a copolymer of the monomer unit (a) and the monomer unit (b), the content of the monomer unit (b) in the liquid farnesene rubber (B) is preferably 10 to 90% by mass, more preferably 20 to 70% by mass, further preferably 20 to 50% by mass. When the content of the monomer unit (b) in the liquid farnesene rubber (B) is 10% by mass or more, the glass transition temperature can be decreased, and when the content is 90% by mass or less, the viscosity decreases, which can enhance the handleability.

The monomer other than farnesene that can form the liquid farnesene rubber (B) is not particularly limited as long as it can be copolymerizable with farnesene. Examples of the monomer other than farnesene include an aromatic vinyl compound, a conjugated diene compound other than farnesene, acrylic acid and a derivative thereof, methacrylic acid and a derivative thereof, acrylamide and a derivative thereof, methacrylamide and a derivative thereof, and acrylonitrile. One of the monomers other than farnesene may be used alone or two or more thereof may be used in combination.

Examples of the aromatic vinyl compound include styrene and styrene derivatives, such as α-methylstyrene, 2-methylstyrene, 3-methylstyrene, 4-methylstyrene, 4-propylstyrene, 4-t-butylstyrene, 4-cyclohexylstyrene, 4-dodecylstyrene, 2,4-dimethylstyrene, 2,4-diisopropylstyrene, 2,4,6-trimethylstyrene, 2-ethyl-4-benzylstyrene, 4-(phenylbutyl)styrene, N,N-diethyl-4-aminoethylstyrene, 4-methoxystyrene, monochlorostyrene, and dichlorostyrene; 1-vinylnaphthalene, 2-vinylnaphthalene, vinylanthracene, and vinylpyridine. Among them, styrene and a derivative thereof are preferred, and styrene is more preferred. One of the aromatic vinyl compounds may be used alone or two or more thereof may be used in combination.

Examples of the conjugated diene compound include butadiene, isoprene, 2,3-dimethylbutadiene, 2-phenylbutadiene, 1,3-pentadiene, 2-methyl-1,3-pentadiene, 1,3-hexadiene, 1,3-octadiene, 1,3-cyclohexadiene, 2-methyl-1,3-octadiene, 1,3,7-octatriene, myrcene, and chloroprene. Among them, butadiene, isoprene, and myrcene are preferred, butadiene is more preferred. One of the conjugated dienes may be used alone or two or more thereof may be used in combination.

Examples of the acrylic acid derivative include methyl acrylate, ethyl acrylate, n-butyl acrylate, isobutyl acrylate, t-butyl acrylate, 2-ethylhexyl acrylate, isooctyl acrylate, isononyl acrylate, lauryl acrylate, stearyl acrylate, cyclohexyl acrylate, isobornyl acrylate, dicyclopentenyloxyethyl acrylate, tetraethylene glycol acrylate, tripropylene glycol acrylate, 4-hydroxybutyl acrylate, 3-hydroxy-1-adamantyl acrylate, tetrahydrofurfuryl acrylate, methoxyethyl acrylate, and N,N-dimethylaminoethyl acrylate. One of the acrylic acid derivatives may be used alone or two or more thereof may be used in combination.

Examples of the methacrylic acid derivative include methyl methacrylate, ethyl methacrylate, n-butyl methacrylate, isobutyl methacrylate, t-butyl methacrylate, 2-ethylhexyl methacrylate, lauryl methacrylate, tridecyl methacrylate, stearyl methacrylate, cyclohexyl methacrylate, isobornyl methacrylate, dicyclopentanyl methacrylate, benzyl methacrylate, dicyclopentenyloxyethyl methacrylate, 2-hydroxyethyl methacrylate, 2-hydroxypropyl methacrylate, 3-hydroxy-1-adamantyl methacrylate, tetrahydrofurfuryl methacrylate, dimethylaminoethyl methacrylate, diethylaminoethyl methacrylate, glycidyl methacrylate and methacrylamide. One of the methacrylic acid derivatives may be used alone or two or more thereof may be used in combination.

Examples of the acrylamide derivative include dimethylacrylamide, acryloylmorpholine, isopropylacrylamide, diethylacrylamide, dimethylaminopropylacrylamide, dimethylaminopropylacrylamide methyl chloride quaternary salt, hydroxyethylacrylamide, and 2-acrylamide-2-methylpropane sulfonic acid. One of the acrylamide derivatives may be used alone or two or more thereof may be used in combination.

Examples of the methacrylamide derivative include dimethylmethacrylamide, methacryloylmorpholine, isopropylmethacrylamide, diethylmethacrylamide, dimethylaminopropylmethacrylamide, and hydroxyethylmethacrylamide. One of the methacrylamide derivatives may be used alone or two or more thereof may be used in combination.

Among the monomers other than farnesene, an aromatic vinyl compound and a conjugated diene compound other than farnesene are preferred, and a conjugated diene compound other than farnesene is more preferred.

The number average molecular weight (Mn) of the liquid farnesene rubber (B) is preferably 10,000 to 150,000, more preferably 20,000 to 100,000, further preferably 25,000 to 80,000. When Mn of the liquid farnesene rubber (B) is 10,000 or more, the curability of the composition can be enhanced and the tackiness before and after curing can be more reduced, and when Mn is 150,000 or less, the composition is superior in moldability. In another embodiment, the number average molecular weight (Mn) of the liquid farnesene rubber (B) is preferably 7,000 to 150,000, more preferably 8,000 to 100,000, further preferably 8,500 to 80,000. When Mn of the liquid farnesene rubber (B) is 7,000 or more, the curability of the composition can be enhanced and the tackiness before and after curing can be more reduced, and when Mn is 150,000 or less, the composition is superior in moldability.

The molecular weight distribution (Mw/Mn) of the liquid farnesene rubber (B) is not particularly limited, and is preferably 1.0 to 2.0, more preferably 1.0 to 1.5, further preferably 1.0 to 1.2, furthermore preferably 1.0 to 1.1. When Mw/Mn of the liquid farnesene rubber (B) is within the above range, the fluctuations in the curability and the tackiness of the composition can be suppressed.

The number average molecular weight and the molecular weight distribution of the liquid farnesene rubber (B) are values based on polystyrenes determined by a GPC measurement by a method described in the section of Examples provided later.

The glass transition temperature (Tg) of the liquid farnesene rubber (B) may vary depending on the bonding mode (microstructure), the contents of the farnesene-derived monomer unit (a) and the monomer unit other than farnesene (b) used as required, and the like, but is preferably -65°C or lower, more preferably -70°C or lower, further preferably -75°C or lower. When Tg of the liquid farnesene rubber (B) is -65°C or lower, in using the composition of the present invention as a printing plate, an enhancement in the high-speed printing performance of the printing plate can be expected. The lower limit of Tg of the liquid farnesene rubber (B) is not particularly limited, and is preferably -100°C or higher, more preferably -90°C or higher, further preferably -85°C or higher. In another embodiment, the glass transition temperature (Tg) of the liquid farnesene rubber (B) is preferably -60°C or lower, more preferably -65°C or lower, further preferably -70°C or lower, and may be -75°C or lower. When Tg of the liquid farnesene rubber (B) is -60°C or lower, in using the composition of the present invention as a printing plate, an enhancement in the high-speed printing performance of the printing plate can be expected. The lower limit of Tg of the liquid farnesene rubber (B) is not particularly limited, and is preferably -100°C or higher, more preferably -90°C or higher, further preferably -85°C or higher.

Tg of the liquid farnesene rubber (B) is determined by differential scanning calorimetry, and more specifically, by a method described in the section of Examples provided later.

The vinyl content of the monomer unit (a) of the liquid farnesene rubber (B) is, from the viewpoints of the curability of the composition and the high-speed printing performance of the printing plate due to Tg as mentioned above, preferably 0.5 to 70% by mole, more preferably 1 to 60% by mole, further preferably 1 to 50% by mole, furthermore preferably 1 to 40% by mole, furthermore preferably 3 to 30% by mole, and particularly preferably 5 to 15% by mole.

In this description, the "vinyl content of the monomer unit (a)" means a content of bonding modes except for the 1,13-bond as shown in the following formula (II) among the farnesene-derived monomer units.

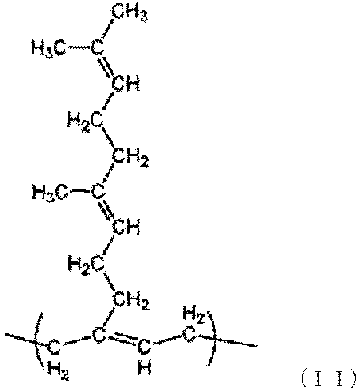

The vinyl content of the liquid farnesene rubber (B) is, from the viewpoints of the curability of the composition and the high-speed printing performance of the printing plate due to Tg as mentioned above, preferably 5 to 80% by mole, more preferably 5 to 60% by mole, further preferably 5 to 50% by mole, furthermore preferably 5 to 45% by mole.

In this description, the "vinyl content of the liquid farnesene rubber (B)" means the total of the vinyl content of the farnesene-derived monomer unit (a) and the vinyl content of the monomer unit other than farnesene (b). The vinyl content of the liquid farnesene rubber (B) is determined by calculating the vinyl content of the farnesene-derived monomer unit (a) and the vinyl content of the monomer unit other than farnesene (b) and adding the vinyl contents. The vinyl content of the farnesene-derived monomer unit (a) and the vinyl content of the monomer unit other than farnesene (b) can be measured by a method using ¹H-NMR described in the section of Examples provided later.

The content of the liquid farnesene rubber (B) based on the total amount of the photosensitive resin composition is preferably 10 to 40% by mass, more preferably 10 to 35% by mass, further preferably 10 to 30% by mass. When the content of the liquid farnesene rubber (B) is 10% by mass or more, the viscosity in molding the composition can be decreased to enhance the processability and in addition, the flexibility of the resulting molded body can be enhanced. The molded body can be preferably used as a printing plate. When the content of the liquid farnesene rubber (B) is 40% by mass or less, the tackiness before and after curing of a molded body obtained by molding the composition can be more reduced. Such characteristics are particularly emphasized in an embodiment in which the molded body is used as a printing plate.

### [Ethylenically Unsaturated Compound (C)]

Examples of the ethylenically unsaturated compound (C) used in the present invention include esters of acrylic acid, methacrylic acid, fumaric acid, maleic acid, and the like, derivatives of acrylamide and methacrylamide, an allyl ester, , and a derivative thereof, and an N-substituted maleimide compound. Specific examples thereof include diacrylates and dimethacrylates of alkanediols, such as hexanediol and nonanediol, diacrylates and dimethacrylates of ethylene glycol, diethylene glycol, propylene glycol, dipropylene glycol, polyethylene glycol, and butylene glycol, trimethylolpropane tri(meth)acrylate, dimethyloltricyclodecane di(meth)acrylate, isoboronyl (meth)acrylate, lauryl (meth)acrylate, phenoxypolyethylene glycol (meth)acrylate, pentaerythritol (meth)acrylate, N,N'-hexamethylene bisacrylamide and methacrylamide, styrene, vinyltoluene, divinylbenzene, diacryl phthalate, triallyl cyanurate, fumaric acid diethyl ester, fumaric acid dibutyl ester, fumaric acid dioctyl ester, fumaric acid distearyl ester, fumaric acid butyl octyl ester, fumaric acid diphenyl ester, fumaric acid dibenzyl ester, maleic acid dibutyl ester, maleic acid dioctyl ester, fumaric acid bis(3-phenylpropyl) ester, fumaric acid dilauryl ester, fumaric acid dibehenyl ester, and N-laurylmaleimide. One of the compounds may be used alone or two or more thereof may be used in combination.

Among them, from the viewpoint of curability, the ethylenically unsaturated compound (C) is preferably an alkanediol di(meth)acrylate.

The content of the ethylenically unsaturated compound (C) based on the total amount of the photosensitive resin composition is preferably 2 to 30% by mass, more preferably 2 to 20% by mass, further preferably 3 to 15% by mass. When the content of the ethylenically unsaturated compound (C) is 2% by mass or more, the curability is enhanced and the formability of fine points and characters on the printing plate can be enhanced, and when the content is 30% by mass or less, the flexibility can be enhanced.

### [Photoinitiator (D)]

As the photoinitiator (D) used in the present invention, a known photoinitiator, such as an aromatic ketone or a benzoin ether, can be used, and examples thereof include 1-hydroxycyclohexyl phenyl ketone, 2-hydroxy-2-methylpropiophenone, diethoxyacetophenone, 1-(4-isopropylphenyl)-2-hydroxy-2-methylpropanone, 1-(4-dodecylphenyl)-2-hydroxy-2-methylpropanone, 4-(2-hydroxyethoxy)-phenyl (2-hydroxy-2-propyl) ketone, 2-methyl-1-[4-(methylthio)phenyl]-2-morpholynopropanone, benzoin, benzoin methyl ether, benzoin ethyl ether, benzoin isopropyl ether, benzoin n-butyl ether, benzoin phenyl ether, benzyl dimethyl ketal, benzophenone, benzoylbenzoic acid, methyl benzoylbenzoate, 4-phenylbenzophenone, 4-methoxybenzophenone, thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone, 2,4,6-trimethylbenzoyldiphenyl phosphine oxide, methylphenylglyoxylate, benzyl, camphorquinone, diphenyl(2,4,6-trimethylbenzoyl)phosphine oxide, and phenylbis(2,4,6-trimethylbenzoyl)phosphine oxide. One of the photoinitiator (D) may be used alone or two or more thereof may be used in combination. Among them, from the viewpoint of the curability, benzyl dimethyl ketal, diphenyl(2,4,6-trimethylbenzoyl)phosphine oxide, and phenylbis(2,4,6-trimethylbenzoyl)phosphine oxide are preferred, and benzyl dimethyl ketal is more preferred.

As the photoinitiator (D), commercial products, such as trade names: "Irgacure 184", "Irgacure 127", "Irgacure 149", "Irgacure 261", "Irgacure 369", "Irgacure 500", "Irgacure 651", "Irgacure 754", "Irgacure 784", "Irgacure 819", "Irgacure 907", "Irgacure 1116", "Irgacure 1173", "Irgacure 1664", "Irgacure 1700", "Irgacure 1800", "Irgacure 1850", "Irgacure 2959", "Irgacure 4043", "Darocure (registered trademark; hereinafter omitted) 1173", and "Darocure MBF" (all manufactured by BASF), are suitably used.

The content of the photoinitiator (D) based on the total amount of the photosensitive resin composition is preferably 0.1 to 10% by mass, more preferably 0.5 to 5% by mass. When the content of the photoinitiator (D) is 0.1% by mass or more, the formability of fine points and characters on the printing plate can be enhanced, and when the content is 10% by mass or less, the transmittance of active light, such as ultraviolet light, can be enhanced.

### [Other Components]

The photosensitive resin composition of the present invention may contain, besides the thermoplastic elastomer (A), the liquid farnesene rubber (B), the ethylenically unsaturated compound (C), and the photoinitiator (D), other components, such as an antioxidant, a plasticizer, a filler, a colorant, a thermal polymerization inhibitor, an ultraviolet light absorber, a halation inhibitor, and a photostabilizer.

The contents of the other components are not particularly limited as long as the effect of the present invention is not impaired, and, based on the total amount of the photosensitive resin composition, are preferably 0.1 to 50% by mass, more preferably 0.5 to 40% by mass, further preferably 0.5 to 30% by mass.

The total content of the thermoplastic elastomer (A), the liquid farnesene rubber (B), the ethylenically unsaturated compound (C), and the photoinitiator (D) in the total amount of the photosensitive resin composition of the present invention is preferably 85% by mass or more, more preferably 90% by mass or more, further preferably 95% by mass or more, and may be 100% by mass or less, may be 98% by mass or less, or may be 96% by mass or less.

### (Method of Producing Photosensitive Resin Composition)

The method for producing the photosensitive resin composition of the present invention is not particularly limited, and any method that can uniformly mix the thermoplastic elastomer (A), the liquid farnesene rubber (B), the ethylenically unsaturated compound (C), the photoinitiator (D), and the aforementioned other compounds can be preferably employed. For mixing, generally, a method in which melt-mixing is performed using a single screw extruder, a twin screw extruder, a kneader, a bunbury mixer, or the like is preferably employed.

The kneading temperature is preferably 100 to 200°C, more preferably 120 to 180°C.

The photosensitive resin composition after kneading can be molded into a sheet having a desired thickness by calender roll, press, extrusion, or the like.

The temperature in molding is preferably 100 to 200°C, more preferably 120 to 180°C.

The photosensitive resin composition of the present invention can be used as a layer constituting a laminated body.

### (Properties of Photosensitive Resin Composition)

The photosensitive resin composition of the present invention preferably shows a tendency to have a low tackiness before curing as compared with a photosensitive resin composition that comprises an alternative to the liquid farnesene rubber (B) which can be an object to be compared. With such a low tackiness before curing, even when a negative film is directly placed on a photosensitive layer composed of the photosensitive resin composition, the negative film can be easily peeled after image exposure to allow the negative film to be reused. In addition, the photosensitive resin composition of the present invention preferably shows a tendency to give a low tackiness after curing as compared with a photosensitive resin composition that comprises an alternative to the liquid farnesene rubber (B) which can be an object to be compared. With such a low tackiness after curing, a flexographic printing plate having a photosensitive layer composed of the photosensitive resin composition has a suppressed stickiness, which suppresses attachment of dust and tear of an object to be printed in printing , thus being superior in the printing performance.

Note that, the tackiness before and after curing of the photosensitive resin composition can be measured by a method described in the section of Examples.

The photosensitive resin composition according to one embodiment has a tackiness before curing at 25°C of preferably 9.5 N or less, more preferably 7.5 N or less, further preferably 6.5 N or less, furthermore preferably 6.0 N or less, and particularly preferably 5.5 N or less. In the photosensitive resin composition of said one embodiment, it is preferred that the thermoplastic elastomer (A) contains a styrene-butadiene-styrene block copolymer, it is more preferred that the thermoplastic elastomer (A) contains a styrene-butadiene-styrene block copolymer and the liquid farnesene rubber (B) contains a monomer unit (a) and a monomer unit (b). The lower limit of the tackiness before curing at 25°C is not particularly limited, and, for example, is 0.1 N or more. When the tackiness before curing at 25°C is 9.5 N or less, the effect as described above is more significantly exhibited.

In addition, the photosensitive resin composition according to said one embodiment has a tackiness after curding at 25°C of preferably 3.0 N or less, more preferably 2.5 N or less, further preferably 2.0 N or less. The lower limit of the tackiness after curding at 25°C is not particularly limited, and, for example, is 0.1 N or more. When the tackiness after curding at 25°C is 3.0 N or less, the effect as described above is more significantly exhibited.

The photosensitive resin composition according to another embodiment has a tackiness before curing at 25°C of preferably less than 14.3 N, more preferably 13.5 N or less, further preferably 13.3 N or less. In the photosensitive resin composition of said another embodiment, it is preferred that the thermoplastic elastomer (A) contains a styrene-isoprene-styrene block copolymer, and it is more preferred that the thermoplastic elastomer (A) contains a styrene-isoprene-styrene block copolymer and the liquid farnesene rubber (B) has a content of the monomer unit (a) of 100% by mass. The lower limit of the tackiness before curing at 25°C is not particularly limited, and, for example, is 0.1 N or more. When the tackiness before curing at 25°C is less than 14.3 N, the effect as described above is more significantly exhibited.

In addition, the photosensitive resin composition according to said another embodiment has a tackiness after curding at 25°C of preferably less than 6.3 N, more preferably 6.2 N or less, further preferably 6.1 N or less. The lower limit of the tackiness after curding at 25°C is not particularly limited, and, for example, is 0.1 N or more. When the tackiness after curding at 25°C is less than 6.3 N, the effect as described above is more significantly exhibited.

The cured product of the photosensitive resin composition of the present invention preferably shows a tendency to have a low rate of extraction of components into a solvent, such as toluene. With such a low rate of extraction, a flexographic printing plate having a photosensitive layer composed of the photosensitive resin composition is suppressed in the temporal change in properties and thus, is superior in the stability of the printing performance. For example, a superior long-running property in long-term use and superior storage stability in long-term storage can be expected. A cured product of the photosensitive resin composition of the present invention more preferably shows such a tendency to have a low tackiness before and after curing as described above while showing a tendency to have a low rate of extraction of components into a solvent, such as toluene.

Note that the rate of extraction of the liquid farnesene rubber (B) of a cured product of the photosensitive resin composition can be measured by a method described in the section of Examples.

A cured product of the photosensitive resin composition according to said one embodiment has a rate of extraction of the liquid farnesene rubber (B) after immersion in toluene at 25°C for 48 hours of preferably 15.0% by mass or less, more preferably 10.0% by mass or less, further preferably 8.0% by mass or less. When the rate of extraction is 15.0% by mass or less, the effect as described above is more significantly exhibited.

A cured product of the photosensitive resin composition according to said another embodiment has a rate of extraction of the liquid farnesene rubber (B) after immersion in toluene at 25°C for 48 hours of preferably 20.0% by mass or less, more preferably 19.0% by mass or less, further preferably 18.0% by mass or less. When the rate of extraction is 20.0% by mass or less, a cured product of the photosensitive resin composition according to said another embodiment tends to be able to exhibit the aforementioned effect to show a tendency to have a low tackiness before and after curing while showing a tendency to have a low rate of extraction.

A cured product of the photosensitive resin composition of the present invention preferably shows a tendency to have a low glass transition temperature (Tg) as compared with a cured product of a photosensitive resin composition that comprises an alternative to the liquid farnesene rubber (B) which can be an object to be compared. With such a low glass transition temperature (Tg), a flexographic printing plate having a photosensitive layer composed of the photosensitive resin composition can be expected to have an enhanced high-speed printing performance.

Note that Tg of a cured product of the photosensitive resin composition can be measured by a method described in the section of Examples.

A cured product of the photosensitive resin composition according to said one embodiment has a glass transition temperature (Tg) of preferably -80°C or lower, more preferably -84°C or lower, further preferably -86°C or lower. When Tg is -80°C or lower, the effect as described above is more significantly exhibited.

The cured product of the photosensitive resin composition according to said another embodiment has a glass transition temperature (Tg) of preferably -57°C or lower, more preferably -59°C or lower, further preferably -61°C or lower. When Tg is -57°C or lower, the effect as described above is more significantly exhibited.

### [Flexographic Printing Plate]

The flexographic printing plate of the present invention has a photosensitive layer composed of the photosensitive resin composition described above.

For example, a sheet of the photosensitive resin composition is placed on a support, and the support and the sheet of the photosensitive resin composition is brough into a close contact by roll lamination, followed by hot press, thereby obtaining a constituent body for a flexographic printing plate in which a photosensitive layer is formed on the support.

The thickness of the photosensitive layer is generally 0.5 to 7 mm, preferably 0.5 to 3.5 mm.

The thickness of the printing plate is generally 0.5 to 7.0 mm, preferably 0.5 to 3.5 mm. The thickness of the printing plate can be changed depending on the object to be printed. When the thickness of the printing plate is to be decreased according to the object to be printed, for example, when the thickness is required to be 3.0 mm or less, the amounts of the components blended in the photosensitive resin composition may be changed, or with reference to said another embodiment, the thermoplastic elastomer (A) in the photosensitive resin composition may contain a styrene-isoprene-styrene block copolymer.

The hardness of the printing plate is generally a type A hardness of 28 to 74, preferably 30 to 65. The hardness of the printing plate can be measured with a type A durometer according to JIS K6253-3:2012. The harness of the printing plate can be changed depending on the object to be printed. When the hardness of the printing plate is to be increased according to the object to be printed, for example, when the type A hardness is required to be 60 or more according to the thickness of the printing plate being 3.0 mm or less, the amounts of components blended in the photosensitive resin composition may be changed, or with reference to said another embodiment, the thermoplastic elastomer (A) in the photosensitive resin composition may contain a styrene-isoprene-styrene block copolymer. Said another embodiment is particularly suitable when the printing plate has a small thickness and a high hardness.

In a general method for forming a flexographic printing plate from the constituent body for the flexographic printing plate, first, the entire surface thereof is subjected to ultraviolet light exposure through the support (back exposure) to provide a thin uniform cured layer on the interface of the photosensitive layer with the support, and then, thorough a negative film that covers the top of the photosensitive layer, the surface of the photosensitive layer is subjected to image exposure (relief exposure) to ultraviolet light. Then an unexposed part of the photosensitive layer is washed out with a developer, or is thermally melted and then removed by absorption with an absorbing layer, followed by post treatment exposure, thus producing a flexographic printing plate.

As image exposure for changing the surface tension of the plate surface, exposure to ultraviolet light of a wavelength in the range of 200 to 300 nm, followed by exposure to ultraviolet light of a wavelength in the range of 310 to 400 nm, may be performed. The exposure on the negative film side (relief exposure) and the exposure on the support side (back exposure) may be performed in either order or may be performed at the same time.

Examples of the light source for the exposure include a high-pressure mercury lamp, an ultraviolet light fluorescent lamp, a carbon ark lamp, a xenon lamp, or a diode lamp.

Examples of a developing solvent used for developing the unexposed part include esters, such as heptyl acetate and 3-methoxybutyl acetate, hydrocarbons, such as a petroleum fraction, toluene, and decalin, and a solvent in which an alcohol, such as propanol, butanol, or pentanol, is mixed with a chlorine-based organic solvent, such as tetrachloroethylene.

The washing out of the unexposed part with the developing solvent is performed by a jet from a nozzle or by brushing with a brush.

As the post-treatment exposure, a method in which the surface is irradiated with light of a wavelength of 300 nm or shorter is generally used. As required, light having a wavelength longer than 300 nm may be used together.

### Examples

Hereinunder, the present invention will be more specifically described with reference to Examples and Comparative Examples, but the present invention is not to be limited thereto.

Components used in Examples and Comparative Examples are as follows.

### [Thermoplastic Elastomer (A)]

· Thermoplastic elastomer (A-1): D-1102JS (trade name, styrene-butadiene-styrene block copolymer manufactured by KRATON CORPORATION, Mw = 120,000, vinyl content = 11% by mole, styrene content = 30% by mass)
· Thermoplastic elastomer (A-2): Quintac (registered trademark) 3421 (trade name, styrene-isoprene-styrene block copolymer manufactured by Zeon Corporation, Mw = 200,000, vinyl content = 7% by mole, styrene content = 14% by mass)

### [Liquid Farnesene Rubber (B)]

· Liquid polyfarnesene butadiene copolymer (B-1): liquid polyfarnesene butadiene copolymer (B-1) produced in Production Example 1 described later
· Liquid polyfarnesene butadiene copolymer (B-2): liquid polyfarnesene butadiene copolymer (B-2) produced in Production Example 2 described later
· Liquid polyfarnesene butadiene copolymer (B-3): liquid polyfarnesene butadiene copolymer (B-3) produced in Production Example 3 described later
· Liquid polyfarnesene (B-4): liquid polyfarnesene (B-4) produced in Production Example 7 described later

### [Liquid Polybutadiene]

· Liquid polybutadiene (b-1): liquid polybutadiene (b-1) produced in Production Example 4 described later
· Liquid polybutadiene (b-2): liquid polybutadiene (b-2) produced in Production Example 5 described later
· Liquid polybutadiene (b-3): liquid polybutadiene (b-3) produced in Production Example 6 described later

### [Ethylenically Unsaturated Compound (C)]

· Ethylenically unsaturated compound (C-1): HDDA (trade name, 1,6-hexanediol diacrylate manufactured by Tokyo Chemical Industry Co., Ltd.)

### [Photoinitiator (D)]

· Photoinitiator (D-1): Irgacure 651 (trade name, manufactured by BASF)

### [Another component]

· Antioxidant :BHT (trade name, dibutylhydroxytoluene manufactured by Kawaguchi Chemical Industry Co., Ltd.)

### <Production Example>

### [Procedure for Purifying Farnesene]

β-Farnesene (purity: 97.6% by mass, manufactured by Amyris Biotechnologies) was purified by purification with a 3Å-molecular sieve, followed by distillation under a nitrogen atmosphere to remove hydrocarbon impurities, such as Zingiberene, Bisabolenes, farnesene epoxide, farnesol isomers, E,E-farnesol, squalene, ergosterol, and several types of dimers of farnesene.

### [Production Example 1] Liquid Polyfarnesene Butadiene Copolymer (B-1)

Into a pressure resistant vessel previously dried with nitrogen purge, 1140 g of cyclohexane as a solvent and 56.2 g of sec-butyllithium (a 10.5% by mass solution in cyclohexane) as a polymerization initiator were charged, and the temperature was increased to 50°C, and then, a previously prepared mixture solution of 1080 g of β-farnesene and 720 g of butadiene was added thereto and was subjected to polymerization for 1 hour. The resulting polymerization reaction solution was treated with methanol, and was washed with water. The washed polymerization reaction solution and water were separated, followed by drying at 70°C for 12 hours, thereby producing a liquid polyfarnesene butadiene copolymer (B-1) which was a random copolymer containing 60% by mass of farnesene units and 40% by mass of butadiene units.

### [Production Example 2] Liquid Polyfarnesene Butadiene Copolymer (B-2)

Into a pressure resistant vessel previously dried with nitrogen purge, 267 g of cyclohexane as a solvent and 7.4 g of sec-butyllithium (a 10.5% by mass solution in cyclohexane) as a polymerization initiator were charged, and the temperature was increased to 50°C, and then, a previously prepared mixture solution of 160 g of β-farnesene and 240 g of butadiene was added thereto and was subjected to polymerization for 2 hours. The resulting polymerization reaction solution was treated with methanol, and was washed with water. The washed polymerization reaction solution and water were separated, followed by drying at 70°C for 12 hours, thereby producing a liquid polyfarnesene butadiene copolymer (B-2) which was a random copolymer containing 40% by mass of farnesene units and 60% by mass of butadiene units.

### [Production Example 3] Liquid Polyfarnesene Butadiene Copolymer (B-3)

Into a pressure resistant vessel previously dried with nitrogen purge, 267 g of cyclohexane as a solvent and 9.3 g of sec-butyllithium (a 10.5% by mass solution in cyclohexane) as a polymerization initiator were charged, and the temperature was increased to 50°C, and then, a previously prepared mixture solution containing 80 g of β-farnesene and 320 g of butadiene was added thereto, and was subjected to polymerization for 2 hours. The resulting polymerization reaction solution was treated with methanol, and was washed with water. The washed polymerization reaction solution and water were separated, followed by drying at 70°C for 12 hours, thereby producing a liquid polyfarnesene butadiene copolymer (B-3) which was a random copolymer containing 20% by mass of farnesene units and 80% by mass of butadiene units.

### [Production Example 4] Liquid Polybutadiene (b-1)

Into a pressure resistant vessel previously dried with nitrogen purge, 400 g of hexane as a solvent and 48.4 g of n-butyllithium (a 17% by mass solution in hexane) as an initiator were charged, and 5.4 g of N,N,N',N'-tetramethylethylenediamine as a polar compound was charged, and the temperature was increased to 50°C, and then, 400 g of butadiene was added thereto and was subjected to polymerization for 1 hour. The resulting polymerization reaction solution was treated with methanol, and was washed with water. The washed polymerization reaction solution and water were separated, followed by drying at 70°C for 12 hours, thereby producing a liquid polybutadiene (b-1).

### [Production Example 5] Liquid Polybutadiene (b-2)

Into a pressure resistant vessel previously dried with nitrogen purge, 400 g of hexane as a solvent and 11.2 g of n-butyllithium (a 17% by mass solution in hexane) as an initiator were charged, and the temperature was increased to 50°C, and then, 400 g of butadiene was added thereto and was subjected to polymerization for 1 hour. The resulting polymerization reaction solution was treated with methanol, and was washed with water. The washed polymerization reaction solution and water were separated, followed by drying at 70°C for 12 hours, thereby producing a liquid polybutadiene (b-2).

### [Production Example 6] Liquid Polybutadiene (b-3)

Into a pressure resistant vessel previously dried with nitrogen purge, 267 g of hexane as a solvent and 60.5 g of n-butyllithium (a 17% by mass solution in hexane) as an initiator were charged, and 2.6 g of N,N,N',N'-tetramethylethylenediamine as a polar compound was charged, and the temperature was increased to 50°C, and then, 400 g of butadiene was added thereto and was subjected to polymerization for 1 hour. The resulting polymerization reaction solution was treated with methanol, and was washed with water. The washed polymerization reaction solution and water were separated, followed by drying at 70°C for 12 hours, thereby producing a liquid polybutadiene (b-3).

### [Production Example 7] Liquid Polyfarnesene (B-4)

Into a pressure resistant vessel previously dried with nitrogen purge, 400 g of cyclohexane as a solvent and 29.8 g of sec-butyllithium (a 10.5% by mass solution in cyclohexane) as a polymerization initiator were charged, and the temperature was increased to 50°C, and then, 400 g of β-farnesene previously prepared was added thereto and was subjected to polymerization for 2 hours. The resulting polymerization reaction solution was treated with methanol, and was washed with water. The washed polymerization reaction solution and water were separated, followed by drying at 70°C for 12 hours, thereby producing a liquid polyfarnesene (B-4).

### [Measurement of Liquid Farnesene Rubber (B) and Liquid Polybutadiene]

The liquid polyfarnesene butadiene copolymers (B-1) to (B-3), the liquid polyfarnesene (B-4), and the liquid polybutadienes (b-1) to (b-3) obtained in Production Examples 1 to 7 (hereinafter also referred to as liquid polymers ) were evaluated for properties according to methods shown below. The results are shown in Table 1.

### [Weight Average Molecular Weight (Mw), Number Average Molecular Weight (Mn), and Molecular Weight Distribution (Mw/Mn)]

Mw, Mn, and Mw/Mn of the liquid polymers were determined by molecular weights based on standard polystyrenes by GPC (gel permeation chromatography). The measurement apparatuses and conditions are as follows.
Apparatus: GPC apparatus "GPC8020" manufactured by TOSOH CORPORATION
Separation Column: "TSKgel G4000HXL" manufactured by TOSOH CORPORATION
Detector: "RI-8020" manufactured by TOSOH CORPORATION
Eluent: tetrahydrofuran
Flow rate of eluent: 1.0 ml/min
Sample concentration: 5 mg/10 ml
Column temperature: 40°C

### [Vinyl Content]

A solution of 50 mg of each liquid polymer dissolved in 1 ml of deuterated chloroform (CDCl₃) was subjected to a measurement with ¹H-NMR (400 MHz) manufactured by Bruker at a cumulative number of 512.

For the farnesene-derived vinyl content, based on the integrated value of each of the following parts in a chart obtained by the measurement, the vinyl content was determined according to the following method.
Part of 4.45 to 4.85 ppm: part A (spectrum derived from vinyl structure of farnesene unit)
Part of 4.94 to 5.22 ppm: part B (synthetic spectrum of spectrum derived from vinyl structure of farnesene unit and spectrum derived from 1,13-bond)
Part of 4.85 to 4.94 ppm: part C (spectrum derived from vinyl structure of butadiene unit)
Part of 5.22 to 5.65 ppm: part D (synthetic spectrum of spectrum derived from vinyl structure of butadiene unit and spectrum derived from 1,4-bond)

For the liquid polyfarnesene butadiene copolymers (B-1) to (B-3), the vinyl content was calculated based on the following formulae. {Vinyl content (derived from farnesene)} = integrated value of part B / 2 / {integrated value of part B / 2 + (integrated value of part B - integrated value of part A) / 3 + integrated value of part C /2 + [integrated value of part D - (integrated value of part C / 2)] / 2} × 100 {Vinyl content (derived from butadiene)} = integrated value of part C / 2 / {integrated value of part C / 2 + [integrated value of part D - (integrated value of part C / 2)] / 2 + integrated value of part B / 2 + (integrated value of part B - integrated value of part A) / 3} × 100 Vinyl content of liquid farnesene rubber (B) = {vinyl content (derived from farnesene)} + {vinyl content (derived from butadiene)}

For the liquid polyfarnesene (B-4), the vinyl content was calculated based on the following formula. {Vinyl content (derived from farnesene)} = integrated value of part B / 2 / {integrated value of part B / 2 + (integrated value of part B - integrated value of part A) / 3} × 100

For the liquid polybutadienes (b-1) to (b-3), the vinyl content was calculated based on the following formula. {Vinyl content (derived from butadiene)} = integrated value of part C / 2 / {integrated value of part C / 2 + [integrated value of part D - (integrated value of part C / 2)] / 2} × 100

### [Glass Transition Temperature (Tg)]

Into an aluminum open pan, 10 mg of each liquid polymer was put, and an aluminum lid was placed thereon and was clamped with a sample sealer. A thermogram was measured with a differential scanning calorimeter (DSC) under a condition of a temperature increase rate of 10°C/min, and the peak top value of DDSC was taken as the glass transition temperature (Tg). The measurement apparatuses and conditions are as follows.

### [Measurement Apparatus and Measurement Conditions]

Apparatus: differential scanning calorimetry "DSC6200" manufactured by Seiko Instruments Inc.
Cooling apparatus: Cooling Controller manufactured by Seiko Instruments Inc.
Detector unit: heat flux type
Sample weight: 10 mg
Temperature increase rate: 10°C/min
Cooling conditions: 10°C/min, after cooling, kept at a constant temperature of -130°C for 3 minutes, followed by starting temperature increase
Reference vessel: aluminum
Reference weight: 0 mg

### [Melt Viscosity (38°C)]

The melt viscosity at 38°C of each liquid polymer was measured with a Brookfield viscometer (manufactured by BROOKFIELD ENGINEERING LABS. INC.).

**Table 1**

| | Weight average molecular weight (Mw) | Number average molecular weight (Mn) | Molecular weight distribution (Mw/Mn) | Vinyl content (% by mole) | | Glass transition temperature Tg (°C) | Melt viscosity at 38°C (Pa·s) |
|---|---|---|---|---|---|---|---|
| | | | | Farnesene-derived | Butadienederived | | |
| Liquid polyfarnesene butadiene copolymer (B-1) | 28800 | 28000 | 1.03 | 6 | 11 | -79 | 12 |
| Liquid polyfarnesene butadiene copolymer (B-2) | 54000 | 53000 | 1.02 | 10 | 33 | -69 | 378 |
| Liquid polyfarnesene butadiene copolymer (B-3) | 46500 | 46000 | 1.01 | 1 | 8 | -89 | 227 |
| Liquid polyfarnesene (B-4) | 9600 | 9000 | 1.07 | 8 | - | -72 | 0.9 |
| Liquid polybutadiene (b-1) | 7400 | 6000 | 1.24 | - | 85 | -21 | 50 |
| Liquid polybutadiene (b-2) | 27800 | 27000 | 1.03 | - | 10 | -94 | 40 |
| Liquid polybutadiene (b-3) | 5000 | 4800 | 1.04 | - | 65 | -49 | 2.7 |

### <First Examples: Examples 1-1 to 1-5 and Comparative Examples 1-1 to 1-3>

Components of kinds and blended amounts shown in Table 2 were kneaded with a mixer having a temperature set to 140°C, thereby preparing a photosensitive resin composition.

The resulting photosensitive resin composition was made into a form in which both surfaces were covered with a polyester film as a cover sheet having a thickness of 100 µm, and was molded with a press machine having a temperature set to 140°C to produce a sheet (hereinafter also referred to as uncured sheet) having a thickness of 2 mm. Next, the resulting uncured sheet was irradiated with ultraviolet light using a UV irradiation machine (manufactured by Heraeus; mercury xenon lamp) under conditions of an illuminance of 500 mJ/cm² and an integrated quantity of light of 8000 mJ/cm², thereby producing a sheet (hereinafter also referred to as cured sheet) having a thickness after curing of 2 mm.

### [Evaluation Method]

The uncured sheets and the cured sheets obtained in Examples and Comparative Examples were evaluated for properties according to methods described below. The results are shown in Table 2.

### (1) Tackiness

Each of the uncured sheets and cured sheets was cut into a size of 2 cm × 10 cm. The cover sheet of the uncured sheet or cured sheet was peeled off, and using PICMA Tack Tester (manufactured by TOYO SEIKI SEISAKU-SHO, LTD.) as a measurement apparatus, the tackiness (stickiness) was measured by a method in which a stainless steel plate and a surface of the uncured sheet or cured sheet were brought into contact for 4 seconds at a rate of 10 mm/min, and then the uncured sheet or cured sheet was peeled from the surface of the stainless steel plate at a rate of 10 mm/min in a vertical direction.

### (2) Rate of extraction

The cured sheet obtained in each of Examples and Comparative Examples was punched into a diameter of 32 mm, and the cover sheet was peeled off, and the cured sheet was immersed in 100 ml of toluene at 25°C for 48 hours, and then, the rate of extraction of the liquid polymer extracted from the cured sheet was calculated based on the weight change.

### (3) Glass transition temperature (Tg)

Into an aluminum open pan, 10 mg of each cured sheet was put, and an aluminum lid was placed thereon and was clamped with a sample sealer. A thermogram was measured with a differential scanning calorimeter (DSC) under a condition of a temperature increase rate of 10°C/min, and the peak top value of DDSC was taken as the glass transition temperature (Tg). Note that the measurement apparatuses and conditions are the same as those in the measurement of the glass transition temperature of liquid polymers.

**Table 2**

| | | unit | Example 1-1 | Example 1-2 | Example 1-3 | Example 1-4 | Example 1-5 | Comparative Example 1-1 | Comparative Example 1-2 | Comparative Example 1-3 |
|---|---|---|---|---|---|---|---|---|---|---|
| Thermoplastic elastomer (A-1) | | % by mass | 68.5 | 68.5 | 68.5 | 76.1 | 68.5 | 68.5 | 68.5 | 68.5 |
| Thermoplastic elastomer (A-2) | | % by mass | - | - | - | - | - | - | - | - |
| Liquid polyfarnesene butadiene copolymer (B-1) | | % by mass | 20 | - | - | 11.1 | 10 | - | - | - |
| Liquid polyfarnesene butadiene copolymer (B-2) | | % by mass | - | 20 | - | - | - | - | - | - |
| Liquid polyfarnesene butadiene copolymer (B-3) | | % by mass | - | - | 20 | - | - | - | - | - |
| Liquid polyfarnesene (B-4) | | % by mass | - | - | - | - | - | - | - | - |
| Liquid polybutadiene (b-1) | | % by mass | - | - | - | - | - | 20 | - | - |
| Liquid polybutadiene (b-2) | | % by mass | - | - | - | - | - | - | 20 | - |
| Liquid polybutadiene (b-3) | | % by mass | - | - | - | - | 10 | - | - | 20 |
| Ethylenically unsaturated compound (C-1) | | % by mass | 8 | 8 | 8 | 8.9 | 8 | 8 | 8 | 8 |
| Photoinitiator (D-1) | | % by mass | 2 | 2 | 2 | 2.2 | 2 | 2 | 2 | 2 |
| Antioxidant | | % by mass | 1.5 | 1.5 | 1.5 | 1.7 | 1.5 | 1.5 | 1.5 | 1.5 |
| Tackiness | before curing | N | 5.8 | 2.8 | 7.4 | 9.0 | 7.0 | 10.0 | 9.9 | 7.5 |
| | after curing | N | 1.9 | 1.4 | 2.1 | 0.7 | 2.1 | 3.1 | 2.1 | 1.9 |
| Rate of extraction | | % by mass | 10.0 | 5.0 | 5.6 | 5.6 | 14.0 | 14.0 | 9.0 | 17.0 |
| Glass transition temperature (Tg) | | °C | -88 | -87 | -90 | -88 | -85 | -80 | -92 | -82 |

It is seen in Table 2 that the photosensitive resin compositions of Examples 1-1 to 1-5 give a low tackiness before and after curing, a low rate of extraction of a liquid polymer after curing, and a low glass transition temperature of a sheet after curing.

### <Second Examples: Examples 2-1 to 2-2 and Comparative Examples 2-1>

Components of kinds and blended amounts shown in Table 3 were kneaded with a mixer having a temperature set to 140°C, thereby preparing a photosensitive resin composition.

The resulting photosensitive resin composition was made into a form in which both surfaces were covered with a polyester film as a cover sheet having a thickness of 100 µm, and was molded with a press machine having a temperature set to 140°C to produce a sheet (uncured sheet) having a thickness of 2 mm. Next, the resulting uncured sheet was irradiated with ultraviolet light using a UV irradiation machine (manufactured by Heraeus; mercury xenon lamp) under conditions of an illuminance of 500 mJ/cm² and an integrated quantity of light of 8000 mJ/cm², thereby producing a sheet (cured sheet) having a thickness after curing of 2 mm.

### [Evaluation Method]

The uncured sheets and the cured sheets obtained in Examples and Comparative Examples were evaluated for properties ((1) tackiness, (2) rate of extraction, and (3) glass transition temperature (Tg)) according to the same methods described for the first Examples. The results are shown in Table 3.

**Table 3**

| | | Unit | Example 2-1 | Example 2-2 | Comparative Example 2-1 |
|---|---|---|---|---|---|
| Thermoplastic elastomer (A-1) | | % by mass | - | - | - |
| Thermoplastic elastomer (A-2) | | % by mass | 68.5 | 68.5 | 68.5 |
| Liquid polyfarnesene butadiene copolymer (B-1) | | % by mass | 20 | - | - |
| Liquid polyfarnesene butadiene copolymer (B-2) | | % by mass | - | - | - |
| Liquid polyfarnesene butadiene copolymer (B-3) | | % by mass | - | - | - |
| Liquid polyfarnesene (B-4) | | % by mass | - | 20 | - |
| Liquid polybutadiene (b-1) | | % by mass | - | - | 20 |
| Liquid polybutadiene (b-2) | | % by mass | - | - | - |
| Liquid polybutadiene (b-3) | | % by mass | - | - | - |
| Ethylenically unsaturated compound (C-1) | | % by mass | 8 | 8 | 8 |
| Photoinitiator (D-1) | | % by mass | 2 | 2 | 2 |
| Antioxidant | | % by mass | 1.5 | 1.5 | 1.5 |
| Tackiness | before curing | N | 13.3 | 9.2 | 14.3 |
| | after curing | N | 6.1 | 4.2 | 6.3 |
| Rate of extraction | | % by mass | 6.8 | 16.5 | 13.3 |
| Glass transition temperature (Tg) | | °C | -65 | -64 | -56 |

It is seen in Table 3 that the photosensitive resin compositions of Examples 2-1 to 2-2 can provide photosensitive resin compositions that give a low tackiness before and after curing while maintaining a low rate of extraction after curing. It is also seen in Table 3 that the photosensitive resin compositions of Example 2-1 to 2-2 also give a low glass transition temperature of a sheet after curing.

### Industrial Applicability

Since the photosensitive resin composition of the present invention has a low tackiness before curing, even when a negative film is directly placed on a photosensitive layer composed of the photosensitive resin composition, the negative film can be easily peeled after image exposure to allow the negative film to be reused. In addition, since the photosensitive resin composition of the present invention gives a low tackiness after curing, a printing plate having a photosensitive layer composed of the photosensitive resin composition has a suppressed stickiness, which suppresses attachment of dust and tear of an object to be printed in printing, and thus being superior in printing performance. In addition, since the photosensitive resin composition of the present invention has a trend to give a low rate of extraction of a liquid polymer after curing, a printing plate having a photosensitive layer composed of the photosensitive resin composition is suppressed in temporal changes in properties, and thus being superior in stability of the printing performance. Accordingly, the photosensitive resin composition of the present embodiment is suitably used for a flexographic printing plate.

## Claims

1. A photosensitive resin composition comprising a thermoplastic elastomer (A), a liquid farnesene rubber (B), an ethylenically unsaturated compound (C), and a photoinitiator (D).

2. The photosensitive resin composition according to claim 1, wherein the thermoplastic elastomer (A) is at least one selected from the group consisting of a styrene-butadiene-styrene block copolymer, a styrene-isoprene-styrene block copolymer, a styrene-(ethylene-butylene)-styrene block copolymer, and a styrene-(ethylene-propylene)-styrene block copolymer.

3. The photosensitive resin composition according to claim 1 or 2, wherein the liquid farnesene rubber (B) comprises a farnesene-derived monomer unit in an amount of 10% by mass or more.

4. The photosensitive resin composition according to any one of claims 1 to 3, wherein the liquid farnesene rubber (B) has a number average molecular weight of 7,000 to 150,000.

5. The photosensitive resin composition according to any one of claims 1 to 4, wherein the liquid farnesene rubber (B) has a glass transition temperature of -60°C or lower.

6. The photosensitive resin composition according to any one of claims 1 to 5, wherein the liquid farnesene rubber (B) has a vinyl content of 5 to 80% by mole.

7. The photosensitive resin composition according to any one of claims 1 to 6, wherein the thermoplastic elastomer (A) is at least one selected from the group consisting of a styrene-butadiene-styrene block copolymer and a styrene-isoprene-styrene block copolymer.

8. The photosensitive resin composition according to claim 7, wherein the thermoplastic elastomer (A) comprises a styrene-butadiene-styrene block copolymer.

9. The photosensitive resin composition according to claim 7, wherein the thermoplastic elastomer (A) comprises a styrene-isoprene-styrene block copolymer.

10. The photosensitive resin composition according to any one of claims 1 to 9, wherein the thermoplastic elastomer (A) is contained in an amount of 40 to 87.9% by mass, the liquid farnesene rubber (B) is contained in an amount of 10 to 40% by mass, the ethylenically unsaturated compound (C) is contained in an amount of 2 to 30% by mass, and the photoinitiator (D) is contained in an amount of 0.1 to 10% by mass, based on the total amount of the photosensitive resin composition.

11. A flexographic printing plate having a photosensitive layer composed of the photosensitive resin composition according to any one of claims 1 to 10.

12. A laminated body having a layer composed of the photosensitive resin composition according to any one of claims 1 to 10.
